# FASCICULE DE BREVET EUROPEEN

(11) **EP 4 293 569 B1**
(45) Date de publication et mention de la délivrance du brevet: **30.07.2025**
(21) Numéro de dépôt: 23169569.3
(22) Date de dépôt: 24.04.2023
(51) Int. Cl.: G06K 19/077, H01L 21/60, B42D 25/00

(54) **INLAY POUR DOCUMENT ELECTRONIQUE, PROCÉDÉ DE FABRICATION D'UN DOCUMENT ÉLECTRONIQUE COMPORTANT UN TEL INLAY, ET DOCUMENT ÉLECTRONIQUE OBTENU**
INLAY FÜR EIN ELEKTRONISCHES DOKUMENT, VERFAHREN ZUR HERSTELLUNG EINES ELEKTRONISCHEN DOKUMENTS MIT EINEM SOLCHEN INLAY UND DIESES ELEKTRONISCHE DOKUMENT
INLAY FOR AN ELECTRONIC DOCUMENT, METHOD FOR PRODUCING AN ELECTRONIC DOCUMENT COMPRISING SUCH AN INLAY, AND RESULTING ELECTRONIC DOCUMENT

(30) Priorité: 16.06.2022 FR 2205916
(43) Date de publication de la demande: 20.12.2023
(73) Titulaire: IDEMIA France, 92400 Courbevoie (FR)
(72) Inventeur: SIRIEIX, Laurent, 92400 Courbevoie (FR); DEPRUN, Jean Francois, 92400 Courbevoie (FR); CHASE, Lui, 92400 Courbevoie (FR)
(74) Mandataire: Idemia

(56) Documents cités:
- EP-A1- 2 178 032
- FR-A1- 3 026 530
- FR-A1- 3 062 225
- FR-A1- 3 093 228

## Description

L'invention concerne un inlay, pour un document électronique, qui comporte au moins un substrat et un fil métallique en zigzag incrusté dans une face supérieure du substrat.

Un « inlay » désigne une couche configurée pour être insérée dans une épaisseur de corps de document électronique.

L'invention concerne aussi un procédé de fabrication d'un document électronique comportant un tel inlay, par exemple tel qu'une carte, comme une carte à puce, ou un document d'identité.

Plus particulièrement l'invention concerne un procédé de fabrication d'un document électronique comportant un corps, dans une épaisseur duquel est inséré un inlay, comprenant une cavité ouverte sur une face du corps, et un module encarté dans la cavité.

Dans un tel document, le corps comporte généralement un inlay ayant un fil, par exemple formant une antenne, dont deux extrémités débouchent dans la cavité, et le module comporte traditionnellement un microprocesseur et deux bornes de connexion qui sont reliées électroniquement d'une part au microprocesseur et d'autre part aux extrémités du fil.

Un tel inlay comporte par exemple un substrat et le fil, formant par exemple l'antenne, qui est incrusté dans le substrat. Un tel inlay est par exemple fabriqué en étendant le fil métallique conducteur sur le substrat au moyen d'un outil, tel qu'une sonotrode, se déplaçant au-dessus du substrat et distribuant le fil. Le fil est incrusté dans le substrat au moyen de vibrations à ultrason transmises au fil depuis l'outil. Les vibrations sont transmises perpendiculairement au substrat pour incruster le fil dans l'épaisseur du substrat. Le fil est par exemple entouré d'une gaine isolante qui est chauffée, par exemple pendant un temps très court, pour améliorer l'adhérence de la gaine au substrat. L'outil est commandé pour définir la trajectoire de dépose du fil. Il est ainsi possible d'enrouler le fil en plusieurs spires et/ou de le déposer selon des lignes de formes diverses, par exemple une ligne sinueuse, comme par exemple en zigzag, ce qui comporte alternativement des segments rectilignes et des détours.

Au sein d'un document électronique, l'inlay est interposé entre au moins deux couches, qui sont donc disposées de part et d'autre de l'inlay, formant ainsi le corps du document. Ces au moins deux couches et l'inlay sont par exemple assemblés ensemble par laminage.

Ensuite, la cavité est formée par usinage, par exemple par fraisage ; au moins l'une des couches est alors usinée, et de manière telle que les extrémités du fil débouchent dans un fond de la cavité, en particulier sur un lamage de la cavité, aussi dit gradin. Toutefois, au moment de l'usinage de la cavité, de l'encartage du module et de la connexion électrique entre le module et les extrémités du fil de l'inlay, plusieurs problèmes peuvent apparaitre.

Par exemple, si l'usinage n'est pas assez profond, un mauvais contact peut s'établir entre les extrémités du fil et le module car une épaisseur de matière, généralement de plastique, peut demeurer sur le fil de l'inlay.

Ou par exemple, si l'usinage est trop profond, l'outil d'usinage, par exemple la fraise, peut arracher une partie du fil de l'inlay. De ce fait, une portion du fil peut présenter un risque important d'être délogée du substrat dans lequel elle était initialement incrustée. Lorsque cette portion de fil est démise, elle se positionne de manière aléatoire dans la cavité. Ceci engendre un risque de dysfonctionnement du document électronique. En particulier, lorsque la portion de fil détachée est située dans la cavité, elle peut venir en contact avec des portions conductrices situées sur une face interne du module, telles que des amenées de courant, créant ainsi un risque non négligeable de court-circuit. De même, lorsque la portion de fil démise se retrouve sur une zone de contact avec les bornes de connexion reliées au microprocesseur, il en résulte une surépaisseur de fil, et donc une zone de contact réduite.

En outre, lors d'essais mécaniques d'un tel document électronique, par exemple des essais de torsion, ou durant la vie du document électronique, une faible connectivité entraine généralement un mauvais fonctionnement du document électronique.

Ces problèmes sont donc dus à diverses tolérances liées, par exemple, à la profondeur d'usinage, à l'épaisseur de fil de l'inlay, à l'épaisseur des différentes couches de matériaux constituant le document électronique, ou encore à la position de l'inlay dans l'épaisseur du corps du document électronique.

La demande de brevet publiée sous le numéro FR3093228 décrit un document électronique dans lequel les extrémités d'une antenne qui débouchent dans la cavité sont agencées en forme de zigzag.

Pour réduire des risques d'arrachage du fil, la demande de brevet publiée sous le numéro FR3026530 décrit un document électronique dans lequel les extrémités d'une antenne qui débouchent dans la cavité sont agencées en forme de zigzag, dont les segments rectilignes sont inclinés d'environ 6° par rapport à un bord de la cavité.

Par ailleurs, le document FR3015733 décrit un document dans lequel un moyen de contact est constitué d'un fil relié électriquement à une extrémité d'une antenne, et agencé de sorte que le fil se développe à partir de l'extrémité de l'antenne en dessinant un lacet définissant des lignes consécutives dirigées alternativement en sens contraires, et étant plus éloignées de l'extrémité de l'antenne que la ligne la précédant et étant reliée à celle-ci par un détour, le moyen de contact étant réalisé affleurant au fond de la cavité et comportant au moins un premier détour disposé en dehors de la cavité. Ainsi, quelle que soit la direction d'arrivée d'une fraise, celle-ci usinera en premier lieu des lignes périphériques les plus éloignées de l'extrémité de l'antenne, diminuant ainsi le risque d'arrachement des lignes situées à proximité de l'extrémité de l'antenne.

Il a également été envisagé d'optimiser la profondeur d'usinage, de sorte qu'il soit suffisamment profond pour avoir un bon contact entre les bornes de connexion du module et des plages de contact de l'inlay, par exemple en supprimant un maximum de plastique sur les fils de l'inlay, mais aussi suffisamment peu profond pour ne pas arracher les fils de l'inlay.

La demande de brevet publiée sous le numéro EP2178032 décrit un document électronique comportant un corps, dans une épaisseur duquel est inséré un inlay, comprenant une cavité ouverte sur une face du corps, et un module encarté dans la cavité.

Un objectif de la présente invention est ainsi d'atténuer au moins en partie les inconvénients précités, pouvant aussi mener à d'autres avantages.

A cet effet, est proposé selon un premier aspect, un inlay comportant au moins un substrat et au moins une première portion en zigzag formée d'un fil métallique incrusté dans une face supérieure du substrat.

Dans le cadre de la présente description, des qualificatifs « premier » ou « deuxième » ne sont qu'à titre indicatif pour distinguer des éléments qu'ils qualifient, mais n'impliquent pas d'ordre entre eux.

Ladite première portion en zigzag est disposée au moins en partie dans une zone de la face supérieure du substrat configurée pour former un lamage d'une cavité.

Un fil en zigzag désigne ici un fil qui est par exemple déposé en formant des allers et retours successifs, formant ainsi des segments rectilignes reliés entre eux par des détours formant des boucles. Les segments rectilignes sont par exemple parallèles les uns aux autres, et deux segments rectilignes adjacents sont par exemple reliés l'un à l'autre par une portion qui est le plus souvent courbe, par exemple en arc de cercle. Un fil en zigzag permet notamment de couvrir une plus grande surface pour établir un contact électrique avec relativement peu de matière.

Le fil en zigzag est par exemple en cuivre.

Ainsi, ici, la première portion en zigzag comporte alternativement des segments rectilignes et des détours, un détour reliant deux segments rectilignes successifs. Selon une caractéristique intéressante de l'invention, au moins l'un des segments rectilignes de la première portion en zigzag est disposé, au moins en partie, dans une zone de la face supérieure du substrat configurée pour former un lamage d'une cavité d'un document électronique.

Et selon une autre caractéristique intéressante de l'invention, l'inlay comporte un fil de connexion configuré pour relier ensemble au moins les segments rectilignes de la première portion en zigzag.

Le fil de connexion désigne ainsi un fil configuré pour connecter électriquement au moins des segments rectilignes de la première portion en zigzag.

Le fil de connexion est par exemple un fil distinct du fil métallique incrusté.

Le fil de connexion est donc un fil électriquement conducteur, par exemple métallique également.

Un tel inlay est par exemple configuré pour être utilisé dans un procédé tel que décrit ci-dessous.

Un tel inlay est ainsi configuré pour procurer un contact électrique plus fiable entre un module encarté et les fils de l'inlay quand ils sont assemblés dans un document électronique.

Une telle disposition améliore une résistance à l'arrachage du fil de l'inlay lors de l'usinage de la cavité.

De plus, une telle disposition des fils procure aussi une meilleure résistance de l'inlay, voire du document électronique autour du module lors de la vie du document électronique.

Il est ainsi possible d'avoir une diminution des contraintes de fabrication du document électronique en diminuant un impact des différentes tolérances de fabrication.

Dans un exemple de réalisation, le fil de connexion comporte une partie qui recoupe au moins la première portion en zigzag en dehors d'une zone de la face supérieure du substrat configurée pour former une partie profonde de la cavité.

La zone de la face supérieure du substrat configurée pour former la partie profonde de la cavité est par exemple entourée par la zone de la face supérieure du substrat configurée pour former le lamage de la cavité.

Dans un exemple de réalisation, le fil de connexion comporte une partie qui recoupe au moins la première portion en zigzag dans une zone de la face supérieure du substrat configurée pour être en dehors de la cavité.

Il s'agit par exemple d'une zone du substrat configurée pour demeurer recouverte par au moins une couche lorsque l'inlay est assemblé entre des couches pour former un corps de document électronique.

Dans un exemple de réalisation, le fil de connexion comporte au moins une partie disposée à côté de la première portion en zigzag.

Par exemple, la partie du fil de connexion, qui est disposée à côté de la première portion en zigzag, comporte au moins un bout disposé dans la zone de la face supérieure du substrat configurée pour former la partie profonde de la cavité.

Cette partie est ainsi configurée pour être coupée lors de l'usinage de la cavité.

Dans un exemple de réalisation, l'au moins l'un des segments rectilignes de la première portion en zigzag forme un angle compris entre 80° et 100° par rapport à une limite entre la zone de la face supérieure du substrat configurée pour former le lamage de la cavité et la zone de la face supérieure du substrat configurée pour former la partie profonde de la cavité.

Dans un exemple de réalisation, l'au moins l'un des segments rectilignes de la première portion en zigzag comporte au moins une extrémité, dite première extrémité qui s'étend dans la zone de la face supérieure du substrat configurée pour être en dehors de la cavité.

Dans un exemple de réalisation, l'au moins l'un des segments rectilignes de la première portion en zigzag comporte une extrémité, dite deuxième extrémité qui s'étend dans la zone de la face supérieure du substrat configurée pour former la partie profonde de la cavité.

Dans un exemple de réalisation, l'inlay comporte en outre au moins une deuxième portion en zigzag, formée de fil métallique, disposée, au moins en partie, dans la zone de la face supérieure du substrat configurée pour former le lamage de la cavité.

La deuxième portion en zigzag comporte par exemple tout ou partie des caractéristiques que la première portion en zigzag décrite précédemment.

La première portion en zigzag et au moins la deuxième portion en zigzag peuvent être formées à partir d'un même fil métallique, ou chacune d'un fil métallique propre.

Autrement dit, dans un exemple de réalisation, l'inlay comporte un fil métallique comportant au moins la première portion en zigzag et la deuxième portion en zigzag. Par exemple, le fil métallique de l'inlay est alors configuré pour réaliser à lui-seul toute connectique d'un document électronique ; i.e. un seul fil métallique peut par exemple comporter toutes les portions en zigzag de l'inlay.

Dans un autre exemple de réalisation, l'inlay comporte au moins deux fils métalliques, chacun des au moins deux fils métalliques comportant au moins une portion en zigzag, voire une seule portion en zigzag.

Dans un exemple de réalisation, le fil de connexion est en outre configuré pour relier ensemble au moins la première portion en zigzag et la deuxième portion en zigzag. Ainsi, un seul test peut permettre de vérifier l'ensemble des connexions.

Est également proposé, selon un autre aspect, un procédé de fabrication d'un document électronique comportant :
- Une étape de fourniture d'un corps du document électronique, le corps comportant au moins :
   ∘ un inlay, tel que décrit ci-dessus ; et
   ∘ au moins une couche supérieure qui recouvre la face supérieure du substrat de l'inlay, et une couche inférieure, le substrat de l'inlay étant disposé entre la couche supérieure et la couche inférieure ;
- Une étape de formation d'une cavité dans le corps, comportant au moins une étape d'usinage d'au moins la couche supérieure du corps au moyen d'un outil d'usinage, dans laquelle l'outil d'usinage a une direction de découpe formant un angle compris entre 80° et 100° par rapport à un segment rectiligne de la première portion en zigzag.

Pour limiter des risques d'arrachage de fil de l'inlay, il est préférable que l'outil d'usinage, par exemple une fraise, rencontre éventuellement un fil selon sa largeur, c'est-à-dire son diamètre. Dans ce cas, une coupure peut intervenir.

Un angle formé entre le fil et l'outil reste de préférence dans une fourchette de valeur pour limiter un risque d'arrachage du fil.

Grace à la présence du fil de connexion, le nombre de coupure(s) n'est pas important, les portions en zigzag étant connectées entre elles par ce fil de connexion.

Ainsi, selon un exemple de mise en œuvre du procédé, l'angle entre l'outil et un segment rectiligne d'une portion en zigzag est d'environ 90 degré, +/-10°.

Dans un exemple de mise en œuvre, l'étape de formation de la cavité dans le corps comporte une étape de formation d'une partie profonde de la cavité dans laquelle la zone de la face supérieure du substrat configurée pour former la partie profonde de la cavité est usinée.

Selon un exemple, la deuxième extrémité de l'au moins l'un des segments rectilignes de la première portion en zigzag est alors coupée par l'outil d'usinage.

Selon un autre exemple, le bout de la partie du fil de connexion, qui est disposée à côté de la première portion en zigzag, est alors coupé par l'outil d'usinage.

En parallèle, les segments rectilignes qui ont été coupés demeurent connectés par le fil de connexion. Il est ainsi possible d'augmenter la surface de contact entre la première portion en zigzag de l'inlay et une borne de connexion d'un module qui sera encarté dans la cavité en fonction des différentes tolérances.

Dans un exemple de réalisation, les segments rectilignes de la première portion en zigzag sont disposés orthogonalement à un bord entre le lamage et la partie profonde de la cavité, c'est-à-dire en formant un angle compris entre 80° et 100° par rapport au bord (soit 90° +/-10°).

Est aussi proposé, selon un autre aspect, un document électronique comportant :
- un corps, lequel comporte :
   - une cavité creusée dans une partie d'une épaisseur du corps, la cavité comportant une partie centrale profonde et une partie périphérique formée d'un lamage, moins profonde que la partie centrale profonde, et entourant la partie centrale profonde, et
   - un inlay comportant au moins un substrat et au moins une première portion en zigzag formée d'un fil métallique incrusté dans une face supérieure du substrat, la première portion en zigzag comportant alternativement des segments rectilignes et des détours, un détour reliant deux segments rectilignes successifs, la première portion en zigzag formant une plage de connexion, exposée sur le lamage,
- le document électronique comportant en outre un module, encarté dans la cavité, et comportant au moins une borne de connexion en contact électrique avec la première portion en zigzag de l'inlay,
- et le document électronique étant caractérisé en ce que l'inlay comporte au moins un fil de connexion reliant ensemble et connectant électriquement les segments rectilignes de la première portion en zigzag.

Un tel document électronique est par exemple une carte, par exemple une carte à puce, avec et/ou sans contact (par exemple une carte duale).

Le corps du document électronique est par exemple conforme aux normes en vigueur, notamment ISO 7810 et ISO 7816.

Selon la norme ISO 7816, le corps peut avoir plusieurs formats, également normalisés. Quatre formats standardisés, connus sous les désignations suivantes (voir notamment la norme ETSI TS 102 221 et la norme ISO 7816), sont principalement utilisés :
- ID-1 ayant une longueur de 85,6 mm, une largeur de 54 mm, et une épaisseur de 0,76 mm ; ce format est parfois désigné par 1FF (pour « premier facteur de forme ») ;
- ID-000 (aussi appelée Plug-in UICC, ou carte SIM GSM) ayant une longueur de 25 mm, une largeur de 15 mm, et la même épaisseur de 0,76 mm ; ce format est parfois désigné par 2FF (pour « deuxième facteur de forme ») ;
- Mini-UICC (parfois aussi appelée carte SIM), avec une longueur de 15 mm, une largeur de 12 mm et la même épaisseur de 0,76 mm ; ce format est parfois désigné par 3FF (pour « troisième facteur de forme ») ;
- Un quatrième format, encore plus petit, appelé nano-SIM ou 4FF (pour « quatrième facteur de forme »), le corps mesurant alors 12,3 mm x 8,8 mm x 0,67 mm.

Les notions de longueur et de largeur sont ici définies par référence à l'orientation du microcircuit.

Les tolérances de l'ensemble des corps décrits ici sont de l'ordre de 0,1 mm, voire 0.05 mm.

Dans un exemple de réalisation, la cavité présente une surface apparente de dimensions environ égales à 13.2 mm * 12 mm (+/- 0.05 mm) pour une cavité pour recevoir un élément sécurisé, par exemple un élément sécurisé configuré pour mettre en œuvre une transaction de paiement selon le standard EMV (« Europay, Mastercard and Visa, par exemple dans sa version 4.3 »), ou 16.3 mm x 16.3 mm (+/- 0.05 mm) pour une cavité configurée pour recevoir un capteur biométrique. Toutes autres dimensions de cavités peuvent également convenir.

Le module de document électronique comporte par exemple au moins un support, aussi appelé film porteur, ou encore selon les cas, substrat isolant, ou vignette, ou plaquette flexible.

Le film comporte une face, dite face externe, car elle est destinée à être accessible de l'extérieur du document électronique équipé de ce module, et une face, dite face interne, opposée à la face externe, et destinée à être orientée vers l'intérieur de la cavité ménagée dans le corps pour recevoir le module.

La face externe du module comporte par exemple une interface externe.

L'interface externe comporte par exemple des interfaces externes de contact selon une configuration bien définie, par exemple par la norme ISO 7816.

L'interface externe peut également comporter un capteur, comme par exemple un capteur biométrique.

La face interne porte par exemple des bornes de connexion connectées électriquement à au moins une partie de l'interface externe de la face externe.

En outre, au moins une borne de connexion est configurée pour être en contact avec une portion en zigzag, formant une plage de connexion, de l'inlay du corps de document électronique.

Le module comporte aussi généralement un microprocesseur, fixé sur la face interne du support.

Le module est par exemple conforme à la norme ISO 7816.

Ainsi, quand le module est encarté dans la cavité, tandis que les bornes de connexion sont en contact sur le lamage, le microprocesseur se situe dans la partie profonde de la cavité.

L'invention, selon un exemple de réalisation, sera bien comprise et ses avantages apparaitront mieux à la lecture de la description détaillée qui suit, donnée à titre indicatif et nullement limitatif, en référence aux dessins annexés dans lesquels :
la figure 1 représente schématiquement un document électronique traditionnel ;
la figure 2 schématise un déplacement d'un outil d'usinage par rapport à une portion de fil selon différentes configurations ;
la figure 3 présente un premier exemple de réalisation de l'invention ;
la figure 4 présente un deuxième exemple de réalisation de l'invention ; et
la figure 5 présente un exemple d'option de réalisation de l'invention.

Les éléments identiques représentés sur les figures précitées sont identifiés par des références numériques identiques.

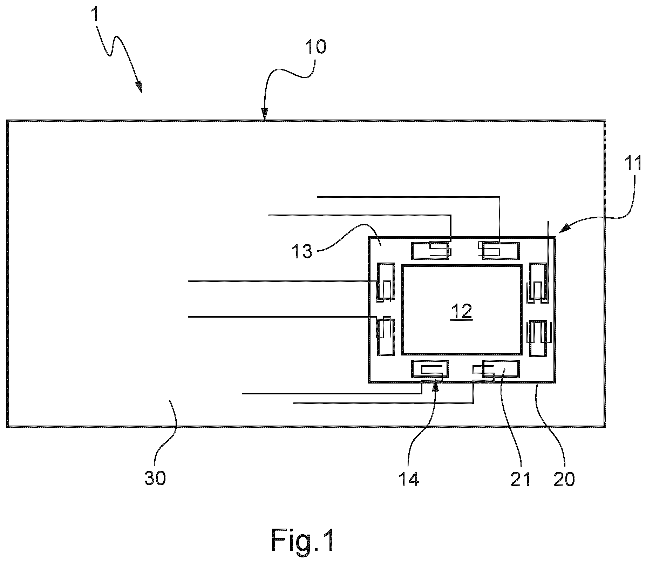

La figure 1 illustre schématiquement un document électronique 1.

Le document électronique 1 comporte par exemple un corps 10.

Le corps 10 comporte ici une cavité 11 creusée dans une partie d'une épaisseur du corps.

La cavité 11 comporte une partie profonde 12, centrale, et un lamage 13, moins profond, et entourant la partie profonde 12.

Le corps 10 comporte traditionnellement au moins une plage de connexion 14, disposée sur le lamage 13, configurée pour rentrer en contact électrique avec une borne de connexion 21 d'un module 20 encarté dans la cavité 11 ; un microprocesseur du module 20 étant alors disposé dans la partie profonde 12 de la cavité.

Pour cela, la plage de connexion 14 est généralement formée dans un inlay 30, laminé dans le corps.

Un « inlay » désigne une couche configurée pour être insérée dans une épaisseur de corps de document électronique, et incidemment, le cas échéant, une couche intermédiaire qui est insérée dans l'épaisseur du corps de document électronique. Cette cavité permet donc par exemple de positionner le module dans le document électronique, et d'accéder aux fils de l'inlay qui se situe dans le corps, et donc de connecter électriquement le module au corps du document.

Dans un tel document électronique, la cavité est généralement fabriquée par usinage, par exemple par fraisage.

Or au cours de la fabrication d'un tel document électronique, plusieurs problèmes peuvent apparaitre, comme notamment un arrachage des fils de l'inlay lors du passage de l'outil d'usinage, ou un mauvais établissement du contact entre l'inlay et le module si l'usinage n'est pas assez profond.

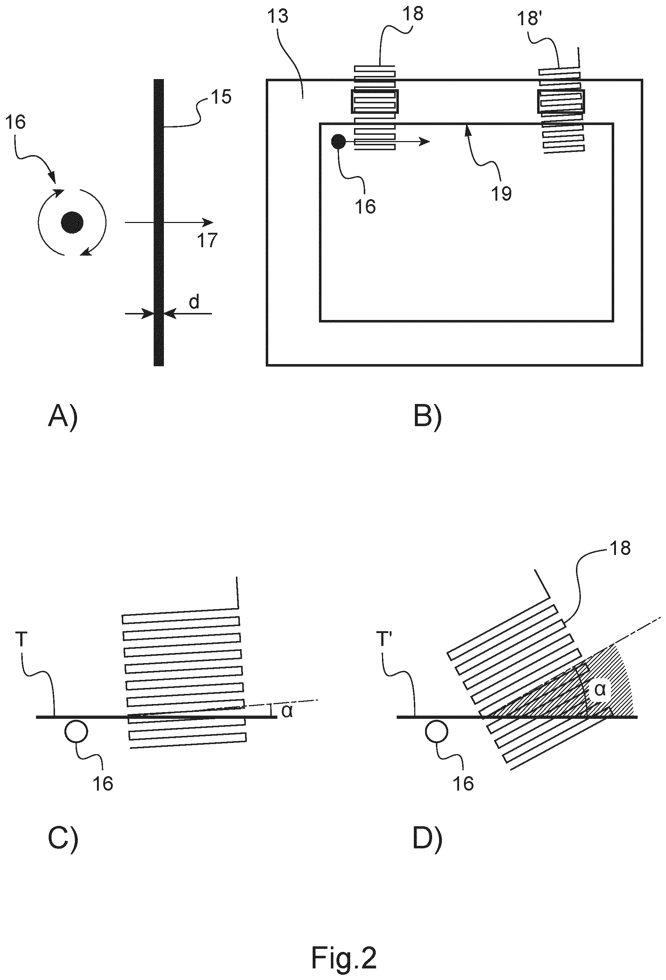

Pour limiter des problèmes d'arrachage, comme l'illustre la figure 2 A), il est apparu préférable que l'outil d'usinage 16 aborde un fil 15 selon son diamètre d, comme schématisé par la flèche 17.

Or, comme l'illustre la figure 2 B), en pratique, un fil en zigzag 18 formant une plage de connexion est disposé avec ses segments rectilignes disposés parallèlement à un bord 19 du lamage 13, ou avec un angle α faible, de sorte que l'outil d'usinage 16 est davantage amené à parcourir les segments rectilignes selon leur longueur.

La figure 2 C) illustre ainsi une trajectoire T d'outil d'usinage 16 ayant un angle α faible, de quelques degrés, par exemple égal ou inférieur à 6° avec un segment rectiligne, tandis que la figure 2 D) illustre ainsi une trajectoire T' d'un outil d'usinage 16 ayant un angle α important, par exemple supérieur à 6° ; par exemple d'environ 35° avec un segment rectiligne. Dans ce dernier cas, de plus nombreux fils 18 peuvent être arrachés, ce qui engendre une parte de connexion, et une réduction de surface utile de la plage de connexion.

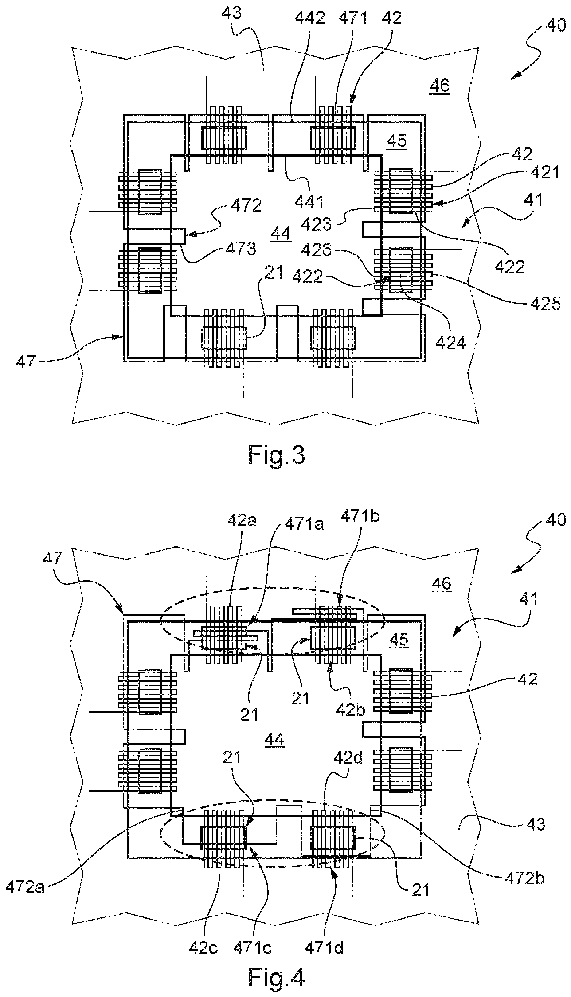

La figure 3 présente un détail d'inlay 40 selon un premier exemple de réalisation de l'invention.

L'inlay 40 comporte au moins un substrat 41.

Le substrat 41 est par exemple formé d'une feuille configurée pour être laminée avec au moins une autre couche pour former un corps de carte.

Il comporte principalement une face supérieure 43, dans laquelle est incrustée au moins un fil métallique. La face supérieure 43 est initialement considérée comme plane.

La face supérieure 43 du substrat 41 comporte plusieurs zones délimitées ici par des pointillés à titre illustratif :
- une zone 44, centrale, configurée pour former une partie profonde de la cavité ;
- une zone 45, périphérique, configurée pour former un lamage d'une cavité d'un document électronique, qui entoure la zone centrale 44 ; et
- une zone 46 configurée pour être en dehors de la cavité, qui, ici, entour la zone périphérique 45 et la zone centrale 44.

En vue d'établir des connexions avec un module, l'inlay 40 comporte aussi ici au moins une première portion en zigzag 42 formée d'un fil métallique incrusté dans la face supérieure 43 du substrat 41.

Ladite portion en zigzag 42 est disposée au moins en partie dans la zone 45 de la face supérieure 43 du substrat 41 configurée pour former un lamage d'une cavité.

Ladite portion en zigzag 42 comporte un fil 421 qui est déposé en formant des allers et retours successifs : il comporte ainsi des segments rectilignes 422 reliées entre eux par des détours 423 formant des boucles. Les segments rectilignes 422 sont ici parallèles les uns aux autres.

Dans le présent exemple de réalisation, au moins l'un des segments rectilignes 422 comporte une partie 424 disposée dans la zone 45 configurée pour former le lamage d'une cavité, ainsi qu'une première extrémité 425 qui s'étend dans la zone 46 configurée pour être en dehors de la cavité, et une deuxième extrémité 426 qui s'étend dans la zone 44 configurée pour former la partie profonde de la cavité.

Ici, les segments rectilignes 422 sont disposés selon un angle compris entre 80° et 100° (soit 90° +/-10° ; i.e. sensiblement orthogonalement) par rapport à une limite 441 entre la zone 44 et la zone 45, ainsi qu'à une limite 442 entre la zone 45 et la zone 46. La limite 441 représente un futur bord 19 entre le lamage et la partie profonde de la cavité et la limite 442 représente un futur bord entre le lamage et une partie hors de la cavité lorsque l'inlay est laminé dans un corps et usiné pour former la cavité.

Dans le présent exemple de réalisation, l'inlay comporte en tout huit portions en zigzag qui présentent tous les mêmes caractéristiques que la première portion en zigzag 42.

Les huit portions en zigzag sont disposées régulièrement au moins en partie dans la zone 45 configurée pour former le lamage de la cavité.

Ici, les huit portions en zigzag sont disposées deux par deux selon quatre côtés d'un rectangle afin de former une cavité rectangulaire.

Sur la figure 3, l'inlay 40 comporte en outre un fil de connexion 47.

Le fil de connexion 47 est configuré pour relier ensemble au moins les segments rectilignes 422 de la première portion en zigzag 42.

Pour cela, le fil de connexion 47 comporte une partie 471 qui recoupe au moins la première portion en zigzag 42 en dehors de la zone 44 configurée pour former une partie profonde de la cavité.

Ceci permet de limiter, voire supprimer, des risques de coupure de la partie 471 lorsque l'inlay est usiné pour former la partie profonde de la cavité.

Dans le présent exemple de réalisation, la partie 471 qui recoupe la première portion en zigzag 42 est même située dans la zone 46 configurée pour être en dehors de la cavité.

Elle est ainsi située dans une zone qui n'est théoriquement pas usinée.

Il s'agit par exemple d'une zone du substrat configurée pour demeurer recouverte par au moins une couche lorsque l'inlay est assemblé entre des couches pour former un corps de document électronique.

Le fil de connexion comporte aussi ici au moins une partie 472 disposée à côté de la première portion en zigzag 42, et qui comporte au moins un bout 473 disposé dans la zone 44 configurée pour former la partie profonde de la cavité.

Cette partie est ainsi configurée pour être coupée lors de l'usinage de la cavité.

En outre, dans le présent exemple de réalisation, toutes les huit portions en zigzag sont reliées par le fil de connexion 47.

Ainsi, le fil de connexion 47 comporte huit parties 471, et huit parties 472, de sorte qu'une fois leur bout 473 coupé, les huit portions en zigzag sont isolées les unes des autres, mais les connexions de leur segments rectilignes entre eux restent assurées par les parties 471.

L'exemple de réalisation de la figure 4 diffère de celui de la figure 3 de par une disposition de certaines parties 471 du fil de connexion 47 qui recoupent chacune une des portions en zigzag, et de par un agencement de certaines parties 472 qui comportent néanmoins au moins un bout 473 disposé dans la zone 44 configurée pour former la partie profonde de la cavité.

Le parcourt du fil de connexion 47 est par exemple ici optimisé pour obtenir un maximum de connexions.

Ainsi, par exemple, les parties 472a et 472b forment ici moins de méandres que sur la figure 3.

Par exemple, la partie 471a, la partie 471c et la partie 471d sont ici disposées dans la zone 45 configurée pour former un lamage, et non plus dans la zone 46 comme la partie 471b.

De plus, la partie 471a et la partie 471b comportent ici un zigzag dont les segments rectilignes sont disposés orthogonalement aux segments rectiligne de la portion en zigzag 42a ou 42b correspondante.

Pour la partie 471a, les segments rectilignes sont alors configurés pour être disposés parallèlement à une trajectoire d'un outil d'usinage.

Par ailleurs, la partie 471a et la partie 471c sont en outre situées de sorte à se retrouver en contact avec des bornes de connexion 21 d'un module lorsque le document électronique correspondant est fabriqué, tandis que la partie 471d est configurée pour contourner une future borne de connexion 21 correspondante.

Ainsi, à partir d'un tel inlay 40, par exemple tel que représenté figure 3 ou figure 4, un document électronique 1 est fabriqué selon un procédé comportant par exemple des étapes suivantes :
- Une étape de fourniture d'un corps 10 du document électronique, le corps comportant au moins :
   ∘ un inlay 40, tel que décrit ci-dessus ; et
   ∘ au moins une couche supérieure qui recouvre la face supérieure du substrat de l'inlay, et une couche inférieure, le substrat de l'inlay étant disposé entre la couche supérieure et la couche inférieure ;
- Une étape de formation d'une cavité 11 dans le corps 10, comportant au moins une étape d'usinage d'au moins la couche supérieure du corps au moyen d'un outil d'usinage 16, dans laquelle l'outil d'usinage 16 a une direction de découpe formant un angle α compris entre 80° et 100° par rapport à un segment rectiligne 422 de la première portion en zigzag 42.

L'étape de formation de la cavité comporte en outre ici une étape de formation de la partie profonde de la cavité dans laquelle la zone 44 du substrat est usinée.

Ainsi pendant cette étape, les deuxièmes extrémités 426 des segments rectilignes 422 des portions en zigzag 42 sont coupées, ainsi que les bouts 473 des parties 472 du fil de connexion 47.

Toutefois, les segments rectilignes demeurent connectés par le fil de connexion 47 grâce aux parties 471 correspondantes.

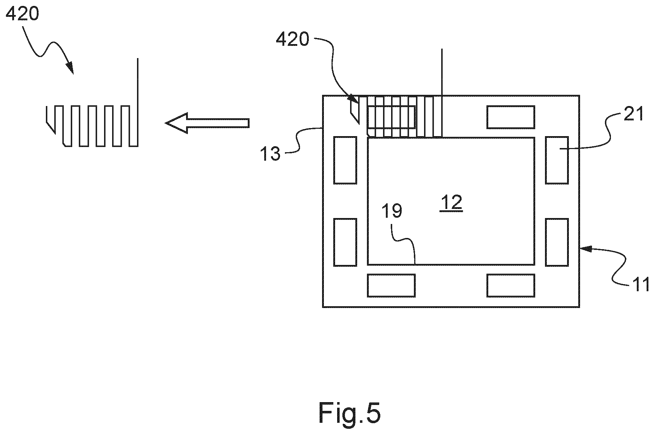

Comme l'illustre la figure 5, il est ainsi possible d'augmenter la surface de contact entre une portion en zigzag 420 de l'inlay et une borne de connexion 21 d'un module qui sera encarté dans la cavité en fonction des différentes tolérances.

Comme illustré sur cette figure, la portion en zigzag peut ainsi s'étendre plus largement que là où se situe la borne de connexion 21.

Cette figure montre également que les segments rectilignes de la portion en zigzag 420 sont disposés orthogonalement à un bord 19 entre le lamage 13 et la partie profonde 12 de la cavité 11, c'est-à-dire en formant un angle compris entre 80° et 100° par rapport au bord (soit 90° +/-10°).

Enfin, cette figure présente à titre illustratif la portion en zigzag 420 selon un autre exemple de réalisation.

Par exemple, le parcourt du fil des portions en zigzag est optimisé pour obtenir un maximum de connexion. Sa conception va ainsi tenir compte des diverses tolérances, par exemple de la localisation des portions en zigzag, du fraisage, de l'agencement du module, des différents fils, etc.

Un tel procédé permet ainsi de réaliser un document électronique comportant :
- Un corps 10, lequel comporte :
   - une cavité 11 creusée dans une partie d'une épaisseur du corps, la cavité comportant une partie centrale profonde 12 et une partie périphérique formée d'un lamage 13, moins profonde que la partie profonde, et entourant la partie profonde, et
   - un inlay 40 comportant au moins une première portion en zigzag 42, formant une plage de connexion, exposée sur le lamage 13, et comportant au moins un fil de connexion 47 reliant ensemble les segments rectilignes 422 de la première portion en zigzag, et
- Un module 20, encarté dans la cavité 11, et comportant au moins une borne de connexion 21 en contact électrique avec première portion en zigzag 42 de l'inlay 40.

Un tel document électronique est par exemple une carte, par exemple une carte à puce, avec et/ou sans contact (par exemple une carte duale).

Le module de document électronique comporte par exemple au moins un support, aussi appelé film porteur, ou encore selon les cas, substrat isolant, ou vignette, ou plaquette flexible, etc.

Le film comporte une face, dite face externe, car elle est destinée à être accessible de l'extérieur du document électronique équipé de ce module, et une face, dite face interne, opposée à la face externe, et destinée à être orientée vers l'intérieur de la cavité ménagée dans le corps pour recevoir le module.

La face externe du module comporte par exemple une interface externe.

L'interface externe comporte par exemple des interfaces externes de contact selon une configuration bien définie, par exemple par la norme ISO 7816.

L'interface externe peut également comporter un capteur, comme par exemple un capteur biométrique.

Le module comporte aussi généralement un microprocesseur, fixé sur la face interne du support disposé alors dans la partie profonde de la cavité.

## Revendications

1. Inlay (40) comportant au moins un substrat (41) et au moins une première portion en zigzag (42) formée d'un fil métallique (421) incrusté dans une face supérieure (43) du substrat (41), la première portion en zigzag (42) comporte alternativement des segments rectilignes (422) et des détours (423), un détour (423) reliant deux segments rectilignes (422) successifs, au moins l'un des segments rectilignes (422) de la première portion en zigzag (42) étant disposé, au moins en partie, dans une zone (45) de la face supérieure (43) du substrat (41) configurée pour former un lamage (13) d'une cavité (11) d'un document électronique (1), et l'inlay (40) étant **caractérisé en ce que** l'inlay comporte un fil de connexion (47) configuré pour relier ensemble et connecter électriquement au moins les segments rectilignes (422) de la première portion en zigzag (42).

2. Inlay (40) selon la revendication 1, **caractérisé en ce que** le fil de connexion (47) comporte une partie (471) qui recoupe au moins la première portion en zigzag (42) en dehors d'une zone (44) de la face supérieure (43) du substrat (41) configurée pour former une partie profonde de la cavité.

3. Inlay (40) selon la revendication 2, **caractérisé en ce que** le fil de connexion (47) comporte au moins une partie disposée à côté de la première portion en zigzag (42), et la partie du fil de connexion (47), qui est disposée à côté de la première portion en zigzag (42), comporte au moins un bout disposé dans la zone (44) de la face supérieure (43) du substrat (41) configurée pour former la partie profonde de la cavité.

4. Inlay (40) selon l'une quelconque des revendications 2 ou 3, **caractérisé en ce que** l'au moins l'un des segments rectilignes (422) de la première portion en zigzag (42) forme un angle compris entre 80° et 100° par rapport à une limite entre la zone (45) de la face supérieure (43) du substrat (41) configurée pour former le lamage (13) de la cavité (11) et la zone (44) de la face supérieure (43) du substrat (41) configurée pour former la partie profonde de la cavité.

5. Inlay (40) selon l'une quelconque des revendications 2 à 4, **caractérisé en ce que** l'au moins l'un des segments rectilignes (422) de la première portion en zigzag (42) comporte une extrémité, dite deuxième extrémité, qui s'étend dans la zone (44) de la face supérieure (43) du substrat (41) configurée pour former la partie profonde de la cavité.

6. Inlay (40) selon l'une quelconque des revendications 1 à 5, **caractérisé en ce que** le fil de connexion (47) comporte une partie ((471) qui recoupe au moins la première portion en zigzag (42) dans une zone (46) de la face supérieure (43) du substrat (41) configurée pour être en dehors de la cavité.

7. Inlay (40) selon la revendication 6, **caractérisé en ce que** l'au moins l'un des segments rectilignes (422) de la première portion en zigzag (42) comporte au moins une extrémité, dite première extrémité, qui s'étend dans la zone de la face supérieure (43) du substrat (41) configurée pour être en dehors de la cavité.

8. Inlay (40) l'une quelconque des revendications 1 à 7, **caractérisé en ce que** l'inlay (40) comporte en outre au moins une deuxième portion en zigzag disposée, au moins en partie, dans la zone (45) de la face supérieure (43) du substrat (41) configurée pour former le lamage (13) de la cavité (1).

9. Inlay (40) selon la revendication 8, **caractérisé en ce que** le fil de connexion (47) est en outre configuré pour relier ensemble au moins la première portion en zigzag (42) et la deuxième portion en zigzag.

10. Procédé de fabrication d'un document électronique (1) comportant :
- Une étape de fourniture d'un corps (10) du document électronique (1), le corps comportant au moins :
- un inlay (40), selon l'une quelconque des revendications 1 à 9 ; et
- au moins une couche supérieure qui recouvre la face supérieure (43) du substrat (41) de l'inlay (40), et une couche inférieure, le substrat (41) de l'inlay (40) étant disposé entre la couche supérieure et la couche inférieure ;
- Une étape de formation d'une cavité (11) dans le corps (10), comportant au moins une étape d'usinage d'au moins la couche supérieure du corps au moyen d'un outil d'usinage, dans laquelle l'outil d'usinage a une direction de découpe formant un angle compris entre 80° et 100° par rapport à un segment rectiligne de la première portion en zigzag (42).

11. Procédé selon la revendication 10, **caractérisé en ce que** l'étape de formation de la cavité (11) dans le corps (10) comporte une étape de formation d'une partie profonde de la cavité dans laquelle la zone (44) de la face supérieure (43) du substrat (41) configurée pour former la partie profonde de la cavité est usinée.

12. Procédé selon la revendication 11, **caractérisé en ce que** la deuxième extrémité de l'au moins l'un des segments rectilignes (422) de la première portion en zigzag (42) est alors coupée par l'outil d'usinage.

13. Procédé selon l'une quelconque des revendications 11 ou 12, **caractérisé en ce que** le bout de la partie du fil de connexion (47), qui est disposée à côté de la première portion en zigzag (42), est alors coupée par l'outil d'usinage.

14. Document électronique (1) comportant :
- un corps (10), lequel comporte :
- une cavité (11) creusée dans une partie d'une épaisseur du corps, la cavité comportant une partie centrale profonde (12) et une partie périphérique formée d'un lamage (13), moins profonde que la partie centrale profonde, et entourant la partie centrale profonde (12), et
- un inlay (40) comportant au moins un substrat (41) et au moins une première portion en zigzag (42) formée d'un fil métallique (421) incrusté dans une face supérieure (43) du substrat (41), la première portion en zigzag (42) comportant alternativement des segments rectilignes (422) et des détours (423), un détour (423) reliant deux segments rectilignes (422) successifs, la première portion en zigzag (42) formant une plage de connexion, exposée sur le lamage (13),
- le document électronique (1) comportant en outre un module (20), encarté dans la cavité (11), et comportant au moins une borne de connexion (21) en contact électrique avec la première portion en zigzag (42) de l'inlay (40),
- et le document électronique (1) étant **caractérisé en ce que** l'inlay comporte au moins un fil de connexion (47) reliant ensemble et connectant électriquement les segments rectilignes de la première portion en zigzag (42).

## Patentansprüche

1. Inlay (40), umfassend mindestens ein Substrat (41) und mindestens einen ersten zickzackförmigen Abschnitt (42), der aus einem Metalldraht (421) gebildet ist, der in eine Oberseite (43) des Substrats (41) eingebettet ist, wobei der erste zickzackförmige Abschnitt (42) abwechselnd geradlinige Segmente (422) und Bögen (423) umfasst, wobei ein Bogen (423) zwei aufeinanderfolgende geradlinige Segmente (422) verknüpft, wobei mindestens eines der geradlinigen Segmente (422) des ersten zickzackförmigen Abschnitts (42) mindestens teilweise in einem Bereich (45) der Oberseite (43) des Substrats (41) angeordnet ist, der dazu konfiguriert ist, einen Absatz (13) eines Hohlraums (11) eines elektronischen Dokuments (1) zu bilden, und wobei das Inlay (40) **dadurch gekennzeichnet ist, dass** das Inlay einen Verbindungsdraht (47) umfasst, der dazu konfiguriert ist, mindestens die geradlinigen Segmente (422) des ersten zickzackförmigen Abschnitts (42) miteinander zu verknüpfen und elektrisch zu verbinden.

2. Inlay (40) nach Anspruch 1, **dadurch gekennzeichnet, dass** der Verbindungsdraht (47) einen Teil (471) umfasst, der mindestens den ersten zickzackförmigen Abschnitt (42) außerhalb eines Bereichs (44) der Oberseite (43) des Substrats (41) schneidet, der dazu konfiguriert ist, einen tiefen Teil des Hohlraums zu bilden.

3. Inlay (40) nach Anspruch 2, **dadurch gekennzeichnet, dass** der Verbindungsdraht (47) mindestens einen Teil umfasst, der neben dem ersten zickzackförmigen Abschnitt (42) angeordnet ist, und der Teil des Verbindungsdrahts (47), der neben dem ersten zickzackförmigen Abschnitt (42) angeordnet ist, mindestens ein Teilstück umfasst, das in dem Bereich (44) der Oberseite (43) des Substrats (41) angeordnet ist, der dazu konfiguriert ist, den tiefen Teil des Hohlraums zu bilden.

4. Inlay (40) nach einem der Ansprüche 2 oder 3, **dadurch gekennzeichnet, dass** das mindestens eine der geradlinigen Segmente (422) des ersten zickzackförmigen Abschnitts (42) mit einer Grenze zwischen dem Bereich (45) der Oberseite (43) des Substrats (41), der dazu konfiguriert ist, den Absatz (13) des Hohlraums (11) zu bilden, und dem Bereich (44) der Oberseite (43) des Substrats (41), der dazu konfiguriert ist, den tiefen Teil des Hohlraums zu bilden, einen Winkel zwischen 80° und 100° bildet.

5. Inlay (40) nach einem der Ansprüche 2 bis 4, **dadurch gekennzeichnet, dass** das mindestens eine der geradlinigen Segmente (422) des ersten zickzackförmigen Abschnitts (42) ein Ende, als zweites Ende bezeichnet, umfasst, das sich in dem Bereich (44) der Oberseite (43) des Substrats (41) erstreckt, der dazu konfiguriert ist, den tiefen Teil des Hohlraums zu bilden.

6. Inlay (40) nach einem der Ansprüche 1 bis 5, **dadurch gekennzeichnet, dass** der Verbindungsdraht (47) einen Teil (471) umfasst, der mindestens den ersten zickzackförmigen Abschnitt (42) in einem Bereich (46) der Oberseite (43) des Substrats (41) schneidet, der dazu konfiguriert ist, sich außerhalb des Hohlraums zu befinden.

7. Inlay (40) nach Anspruch 6, **dadurch gekennzeichnet, dass** das mindestens eine der geradlinigen Segmente (422) des ersten zickzackförmigen Abschnitts (42) mindestens ein Ende, als erstes Ende bezeichnet, umfasst, das sich in dem Bereich der Oberseite (43) des Substrats (41) erstreckt, der dazu konfiguriert ist, sich außerhalb des Hohlraums zu befinden.

8. Inlay (40) nach einem der Ansprüche 1 bis 7, **dadurch gekennzeichnet, dass** das Inlay (40) ferner mindestens einen zweiten zickzackförmigen Abschnitt umfasst, der mindestens teilweise in dem Bereich (45) der Oberseite (43) des Substrats (41) angeordnet ist, der dazu konfiguriert ist, den Absatz (13) des Hohlraums (1) zu bilden.

9. Inlay (40) nach Anspruch 8, **dadurch gekennzeichnet, dass** der Verbindungsdraht (47) ferner dazu konfiguriert ist, mindestens den ersten zickzackförmigen Abschnitt (42) und den zweiten zickzackförmigen Abschnitt miteinander zu verknüpfen.

10. Verfahren zur Herstellung eines elektronischen Dokuments (1), umfassend:
- einen Schritt des Bereitstellens eines Körpers (10) des elektronischen Dokuments (1), wobei der Körper mindestens Folgendes umfasst:
- ein Inlay (40) nach einem der Ansprüche 1 bis 9; und
- mindestens eine Oberschicht, die die Oberseite (43) des Substrats (41) des Inlays (40) bedeckt, und eine Unterschicht, wobei das Substrat (41) des Inlays (40) zwischen der Oberschicht und der Unterschicht angeordnet ist;
- einen Schritt des Bildens eines Hohlraums (11) in dem Körper (10), umfassend mindestens einen Schritt des Bearbeitens mindestens der Oberschicht des Körpers mit Hilfe eines Bearbeitungswerkzeugs, während dessen das Bearbeitungswerkzeug eine Schnittrichtung aufweist, die mit einem geradlinigen Segment des ersten zickzackförmigen Abschnitts (42) einen Winkel zwischen 80° und 100° bildet.

11. Verfahren nach Anspruch 10, **dadurch gekennzeichnet, dass** der Schritt des Bildens des Hohlraums (11) in dem Körper (10) einen Schritt des Bildens eines tiefen Teils des Hohlraums umfasst, während dessen der Bereich (44) der Oberseite (43) des Substrats (41) bearbeitet wird, der dazu konfiguriert ist, den tiefen Teil des Hohlraums zu bilden.

12. Verfahren nach Anspruch 11, **dadurch gekennzeichnet, dass** das zweite Ende des mindestens einen der geradlinigen Segmente (422) des ersten zickzackförmigen Abschnitts (42) dann durch das Bearbeitungswerkzeug abgetrennt wird.

13. Verfahren nach einem der Ansprüche 11 oder 12, **dadurch gekennzeichnet, dass** das Teilstück des Teils des Verbindungsdrahts (47), der neben dem ersten zickzackförmigen Abschnitt (42) angeordnet ist, dann durch das Bearbeitungswerkzeug abgetrennt wird.

14. Elektronisches Dokument (1), umfassend:
- einen Körper (10), der Folgendes umfasst:
- einen Hohlraum (11), der in einen Teil einer Dicke des Körpers eingebracht ist, wobei der Hohlraum einen tiefen Mittelteil (12) und einen Umfangsteil, der durch einen Absatz (13), der weniger tief als der tiefe Mittelteil ist, gebildet wird und den tiefen Mittelteil (12) umgibt, umfasst, und
- ein Inlay (40), das mindestens ein Substrat (41) und mindestens einen ersten zickzackförmigen Abschnitt (42), der durch einen in eine Oberseite (43) des Substrats (41) eingebetteten Metalldraht (421) gebildet ist, umfasst, wobei der erste zickzackförmige Abschnitt (42) abwechselnd geradlinige Segmente (422) und Bögen (423) umfasst, wobei ein Bogen (423) zwei aufeinanderfolgende geradlinige Segmente (422) verknüpft, wobei der erste zickzackförmige Abschnitt (42) eine Verbindungszone bildet, die auf dem Absatz (13) eingerichtet ist,
- wobei das elektronische Dokument (1) ferner ein Modul (20) umfasst, das in den Hohlraum (11) eingelegt ist und mindestens einen Verbindungsanschluss (21) in elektrischem Kontakt mit dem ersten zickzackförmigen Abschnitt (42) des Inlays (40) umfasst,
- und wobei das elektronische Dokument (1) **dadurch gekennzeichnet ist, dass** das Inlay mindestens einen Verbindungsdraht (47) umfasst, der die geradlinigen Segmente des ersten zickzackförmigen Abschnitts (42) miteinander verknüpft und elektrisch verbindet.

## Claims

1. Inlay (40) comprising at least one substrate (41) and at least one first zigzag portion (42) formed of a metal wire (421) embedded in an upper face (43) of the substrate (41), the first zigzag portion (42) comprising, alternately, rectilinear segments (422) and bends (423), a bend (423) connecting two successive rectilinear segments (422), at least one of the rectilinear segments (422) of the first zigzag portion (42) being disposed, at least in part, in a zone (45) of the upper face (43) of the substrate (41) configured to form a spotface (13) of a cavity (11) of an electronic document (1), and the inlay (40) being **characterized in that** the inlay comprises a connection wire (47) configured to join together and electrically connect at least the rectilinear segments (422) of the first zigzag portion (42) .

2. Inlay (40) according to Claim 1, **characterized in that** the connection wire (47) comprises a part (471) which intersects at least the first zigzag portion (42) outside a zone (44) of the upper face (43) of the substrate (41) configured to form a deep part of the cavity.

3. Inlay (40) according to Claim 2, **characterized in that** the connection wire (47) comprises at least one part disposed next to the first zigzag portion (42), and that part of the connection wire (47) disposed next to the first zigzag portion (42) comprises at least one end disposed **in that** zone (44) of the upper face (43) of the substrate (41) configured to form the deep part of the cavity.

4. Inlay (40) according to either of Claims 2 and 3, **characterized in that** the at least one of the rectilinear segments (422) of the first zigzag portion (42) forms an angle of between 80° and 100° with respect to a limit between that zone (45) of the upper face (43) of the substrate (41) configured to form the spotface (13) of the cavity (11) and that zone (44) of the upper face (43) of the substrate (41) configured to form the deep part of the cavity.

5. Inlay (40) according to any one of Claims 2 to 4, **characterized in that** the at least one of the rectilinear segments (422) of the first zigzag portion (42) comprises an end, called a second end, which extends **in that** zone (44) of the upper face (43) of the substrate (41) configured to form the deep part of the cavity.

6. Inlay (40) according to any one of Claims 1 to 5, **characterized in that** the connection wire (47) comprises a part (471) which intersects at least the first zigzag portion (42) in a zone (46) of the upper face (43) of the substrate (41) configured to be outside the cavity.

7. Inlay (40) according to Claim 6, **characterized in that** the at least one of the rectilinear segments (422) of the first zigzag portion (42) comprises at least one end, called a first end, which extends **in that** zone of the upper face (43) of the substrate (41) configured to be outside the cavity.

8. Inlay (40) according to any one of Claims 1 to 7, **characterized in that** the inlay (40) additionally comprises at least one second zigzag portion disposed, at least in part, **in that** zone (45) of the upper face (43) of the substrate (41) configured to form the spotface (13) of the cavity (1).

9. Inlay (40) according to Claim 8, **characterized in that** the connection wire (47) is additionally configured to join together at least the first zigzag portion (42) and the second zigzag portion.

10. Method for producing an electronic document (1), comprising:
- a step of making available a body (10) of the electronic document (1), the body comprising at least:
- an inlay (40), according to any one of Claims 1 to 9; and
- at least one upper layer which covers the upper face (43) of the substrate (41) of the inlay (40), and a lower layer, the substrate (41) of the inlay (40) being disposed between the upper layer and the lower layer;
- a step of forming a cavity (11) in the body (10), comprising at least one step of machining at least the upper layer of the body by means of a machine tool, in which step the machine tool has a cutting direction forming an angle of between 80° and 100° with respect to a rectilinear segment of the first zigzag portion (42).

11. Method according to Claim 10, **characterized in that** the step of forming the cavity (11) in the body (10) comprises a step of forming a deep part of the cavity, in which step that zone (44) of the upper face (43) of the substrate (41) configured to form the deep part of the cavity is machined.

12. Method according to Claim 11, **characterized in that** the second end of the at least one of the rectilinear segments (422) of the first zigzag portion (42) is then cut by the machine tool.

13. Method according to either of Claims 11 and 12, **characterized in that** the end of that part of the connection wire (47) disposed next to the first zigzag portion (42) is then cut by the machine tool.

14. Electronic document (1) comprising:
- a body (10), which comprises:
- a cavity (11) hollowed out in a part of a thickness of the body, the cavity comprising a deep central part (12) and a peripheral part, formed of a spotface (13), less deep than the deep central part and surrounding the deep central part (12), and
- an inlay (40) comprising at least one substrate (41) and at least one first zigzag portion (42) formed of a metal wire (421) embedded in an upper face (43) of the substrate (41), the first zigzag portion (42) comprising, alternately, rectilinear segments (422) and bends (423), a bend (423) connecting two successive rectilinear segments (422), the first zigzag portion (42) forming a connection pad, exposed on the spotface (13),
- the electronic document (1) further comprising a module (20), inserted into the cavity (11), and comprising at least one connection terminal (21) in electrical contact with the first zigzag portion (42) of the inlay (40),
- and the electronic document (1) being **characterized in that** the inlay comprises at least one connection wire (47) joining together and electrically connecting the rectilinear segments of the first zigzag portion (42).
